# DEMANDE DE BREVET EUROPEEN

(11) **EP 3 273 371 A1**
(43) Date de publication de la demande: **24.01.2018**
(21) Numéro de dépôt: 17181306.6
(22) Date de dépôt: 13.07.2017
(51) Int. Cl.: G06F 17/50

(54) **PROCEDE DE CONSTRUCTION D'UN MODELE PREDICTIF**

(30) Priorité: 18.07.2016 FR 1656826
(71) Demandeur: Schneider Electric Industries SAS, 92500 Rueil-Malmaison (FR)
(72) Inventeur: CLEMENCE, Michel, 38050 GRENOBLE Cedex 9 (FR); DESCHAMPS, Philippe, 38050 GRENOBLE Cedex 9 (FR); CHOLLOT, Yves, 38050 GRENOBLE Cedex 9 (FR); BENOIT, Clémentine, 38050 GRENOBLE Cedex 9 (FR)
(74) Mandataire: Brevalex

(57) **Abrégé**

L'invention concerne un procédé de construction d'un modèle prédictif de changement d'état d'un réseau de distribution électrique (1), le réseau de distribution électrique comprenant un noeud (N) alimentant des charges (2) connectées par l'intermédiaire d'une ligne de distribution (3), le procédé comprenant :
a) une étape de mesure de l'évolution, pendant une première période temporelle, d'une grandeur physique A au niveau du noeud principal (N), et d'une grandeur physique B au niveau des points (4) de mesure du réseau (1) ;
b)une étape de corrélation de la grandeur A et de la grandeur B mesurées à l'étape a), de sorte que la connaissance de la grandeur physique A, au niveau du noeud principal (N) permette de prédire la valeur de la grandeur physique B au niveau de la pluralité de points (4) de mesure du réseau (1).

## Description

### DOMAINE TECHNIQUE

La présente invention concerne un procédé de réalisation d'un modèle prédictif d'une grandeur caractéristique d'un réseau de distribution électrique. L'invention concerne également la mise en oeuvre du modèle prédictif de la grandeur caractéristique afin d'assurer la stabilité du réseau de distribution d'électricité, et plus particulièrement, d'un réseau basse tension.

### ART ANTÉRIEUR

Un réseau de distribution d'électricité basse tension (BT, par basse tension, on entend une tension compris inférieure à 1000 Volts) est généralement alimenté en courant au niveau d'un noeud principal à partir duquel il est interfacé à un réseau moyenne tension (MT, par moyenne tension on entend une tension supérieure ou égale à 1000 Volts) par l'intermédiaire d'un poste de transformation, dit poste MT/BT. Un réseau BT comprend également une pluralité de lignes de distribution BT qui acheminent le courant du noeud principal vers des utilisateurs, par exemple des utilisateurs domestiques, raccordés audit réseau BT.

L'ensemble de ce réseau est conçu pour garantir un niveau de tension prédéterminé aux consommateurs. Des fluctuations de tension des lignes de distribution BT peuvent, néanmoins, être observées dès lors que la consommation et/ou la production en courant des utilisateurs varient. Aussi, afin de minimiser les fluctuations de tension, le poste MT/BT peut être asservi par un module de régulation destiné à compenser les fluctuations de tension, et ainsi préserver la stabilité des réseaux BT. Un tel mode d'asservissement est par exemple décrit dans le document FR 2 787 248.

Cependant, ces dernières années ont été marquées par l'émergence des sources de production d'énergie électrique décentralisées, telles que des sources d'énergie renouvelable, qui alimentent également en courant les lignes de distribution BT. Les sources de production décentralisées peuvent être disposées chez certains utilisateurs, et produire de l'électricité de manière intermittente ou non contrôlée, notamment dans le cas de sources d'énergie renouvelable, et par conséquent induire des déséquilibres de tension entre les différentes lignes de distribution BT connectées au noeud principal. Par exemple, la tension d'une ligne de distribution BT peut évoluer à la hausse dès lors qu'elle est alimentée en courant par une source de production décentralisée, pendant que la tension d'autres lignes de distribution BT diminue du fait d'une augmentation de la consommation par les utilisateurs.

Ainsi, la présence de sources de production décentralisées entraîne des disparités du niveau de tension qui rendent les modes de régulation précédemment cités inopérants.

Par ailleurs, la régulation du réseau BT avec un poste de transformation nécessite de connaître le comportement de ladite ligne face à des variations de tension.

Cependant, la méconnaissance de la structure précise des réseaux BT, donc des différentes lignes de distribution BT le constituant, empêche toute modélisation ou constitution d'abaques caractérisant lesdites lignes de distribution BT.

Un but de la présente invention est de proposer un procédé de détermination d'un modèle prédictif de changement d'état d'un réseau de distribution électrique.

Un autre but de la présente invention est alors de proposer un procédé permettant de réguler la tension d'un réseau de distribution électrique, par exemple un réseau BT.

### EXPOSÉ DE L'INVENTION

Les buts de l'invention sont, au moins en partie, atteints par un procédé de construction d'un modèle prédictif de changement d'état d'un réseau de distribution électrique destiné à être mise en oeuvre pour la régulation dynamique dudit réseau, le réseau de distribution électrique comprenant un noeud principal alimentant en courant une pluralité de charges connectées audit noeud principal par l'intermédiaire d'au moins une ligne de distribution, le procédé comprenant :
a) une étape de mesure, pendant une première période de temps, d'au moins une grandeur physique A au niveau du noeud principal, et d'au moins une grandeur physique B au niveau d'une pluralité de points de mesure du réseau ;
b)une étape de corrélation, exécutée au moyen d'un calculateur, de l'au moins une grandeur A et de l'au moins une grandeur B mesurées à l'étape a), de sorte que la connaissance de l'au moins une grandeur physique A au niveau du noeud principal permette de prédire la valeur de l'au moins une grandeur physique B au niveau de la pluralité de points de mesure du réseau.

Selon un mode de mise en oeuvre, l'étape b) de corrélation comprend un algorithme d'apprentissage machine, avantageusement selon une méthode de machine à vecteurs de support.

Selon un mode de mise en oeuvre, la grandeur physique A comprend au moins une des grandeurs physiques choisie parmi : le tension, l'intensité du courant, la puissance active, la puissance réactive.

Selon un mode de mise en oeuvre, la grandeur physique B est une tension.

Selon un mode de mise en oeuvre, l'étape a) de mesure est réalisée par une pluralité de capteurs localisés au niveau du noeud principal et de la pluralité de points de mesure.

Selon un mode de mise en oeuvre, le réseau de distribution électrique comprend des sources de production d'énergie électrique décentralisées, avantageusement les sources de production décentralisées comprennent des sources d'énergie renouvelables.

Selon un mode de mise en oeuvre, la première période temporelle est d'une durée inférieure à un mois, avantageusement inférieure à une semaine.

Selon un mode de mise en oeuvre, l'au moins une ligne de distribution est ramifiée est comprend une pluralité de terminaisons constituants des points de mesure de la grandeur physique B.

Selon un mode de mise en oeuvre, le réseau de distribution électrique comprend trois phases et un neutre, les étapes a) et b) étant exécutées sur les trois phases et le neutre.

L'invention concerne également un procédé de régulation dynamique d'un réseau de distribution électrique comprenant un noeud principal alimentant en courant une pluralité de charges connectées audit noeud principal par l'intermédiaire d'au moins une ligne de distribution, la valeur d'au moins une grandeur physique B en une pluralité de points du réseau de distribution électrique étant corrélée à la valeur d'une grandeur physique A au noeud principal selon le modèle prédictif construit,

Le procédé comprenant la prédiction de la valeur de l'au moins une grandeur physique B à partir de la mesure de la valeur de l'au moins une grandeur physique A, le procédé comprenant entre outre un ajustement de la valeur de la grandeur physique A, par application du modèle prédictif, destiné à maintenir la valeur de l'au moins une grandeur physique B dans une gamme de valeurs prédéterminées.

Selon un mode de mise en oeuvre, le réseau de distribution électrique est interfacé à un réseau d'alimentation au niveau du noeud principal par l'intermédiaire d'un poste de transformation.

Selon un mode de mise en oeuvre, l'ajustement de la grandeur physique A est exécuté par le poste de transformation.

Selon un mode de mise en oeuvre, le poste de transformation comprend un régulateur destiné à exécuter la mesure de la valeur de l'au moins une grandeur physique A et la prédiction de la valeur de l'au moins une grandeur physique B, ledit régulateur étant également adapté pour commander au poste de transformation l'ajustement de la valeur de l'au moins une grandeur physique A.

Selon un mode de mise en oeuvre, le réseau de distribution électrique est un réseau BT.

Selon un mode de mise en oeuvre, le réseau de distribution électrique comprend des sources de production d'énergie électrique décentralisées, avantageusement les sources de production décentralisées comprennent des sources d'énergie renouvelables.

### BRÈVE DESCRIPTION DES DESSINS

D'autres caractéristiques et avantages apparaîtrons dans la description qui va suivre des modes de mise en oeuvre du procédé de construction d'un modèle prédictif de changement d'état d'un réseau de distribution électrique selon l'invention, donnés à titre d'exemples non limitatifs, en référence aux dessins annexés dans lesquels :
- la figure 1 est une représentation schématique d'un réseau de distribution destiné à être régulé selon l'invention,
- la figure 2 est un schéma de principe de mise en oeuvre de la construction du modèle prédictif selon l'invention,
- les figures 3a, 3b et 3c représentent, pour chacune des phases a, b, et c d'un réseau basse tension triphasé, l'évolution des tensions Vₐ, V_{b}, et V_{c} (sur l'axe vertical) en fonction du temps (sur l'axe horizontal) de la tension prédite par le modèle prédictif selon l'invention et la tension effectivement mesurée.

### EXPOSÉ DÉTAILLÉ DE MODES DE RÉALISATION PARTICULIERS

L'invention décrite de manière détaillée ci-dessous met en oeuvre la construction d'un modèle prédictif de changement d'état d'un réseau de distribution électrique destiné à permettre une meilleure régulation des réseaux de distribution d'électricité. Plus particulièrement, le procédé selon l'invention met en oeuvre une méthode d'apprentissage destinée à détecter les changements d'états du réseau de distribution d'électricité, et ainsi permettre sa régulation de manière dynamique.

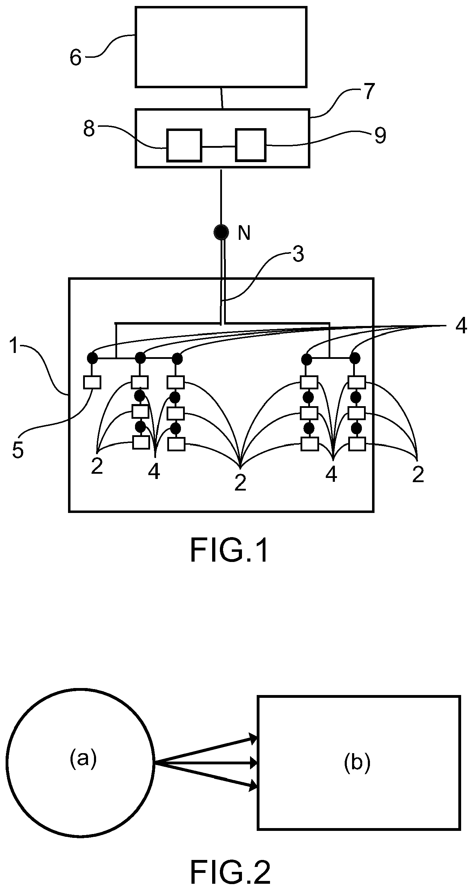

La figure 1 représente un réseau de distribution électrique 1. Le réseau de distribution électrique 1 est interfacé à un réseau d'alimentation 6 à partir de son noeud principal N via un poste de transformation 7 comprenant un transformateur 8 (par exemple un transformateur MT/BT).

Au niveau du noeud N (ou du poste de transformation 7), on peut compter une pluralité de départs de lignes de distribution 3 alimentant en courant des charges 2 (Par charge 2, nous entendons des organes de consommation d'électricité). Par exemple, le réseau de distribution d'électricité 1 peut être un réseau BT connecté à un réseau MT (le réseau d'alimentation 6) par l'intermédiaire d'un poste MT/BT à partir duquel on peut compter entre 1 et 20 départs de lignes de distribution 3.

Les lignes de distribution 3 peuvent être triphasées (autrement dit les lignes de distribution 3 comprennent trois phases et un neutre), et présentent généralement des ramifications.

Le réseau de distribution d'électricité 1 peut également comprendre des sources de production décentralisées 5. Par sources de production décentralisée 5, on entend des sources de production d'électricité connectées audit réseau de distribution d'électricité 1 au niveau des lignes de distribution 3, et à distance du noeud principal N.

Les sources de production décentralisées sont par exemple des sources de production d'énergie renouvelable, plus particulièrement des sources d'énergie photovoltaïque, ou des sources d'énergie éolienne.

Un premier aspect de l'invention, illustré à la figure 2, concerne l'établissement d'un modèle prédictif de changement d'état du réseau de distribution électrique 1. Par exemple, le changement d'état du réseau de distribution électrique peut correspondre à une variation d'une grandeur physique B en au moins un point dudit réseau 1. Plus particulièrement, la grandeur physique B peut par exemple être une tension électrique (ci-après nommée « tension »). Le changement d'état du réseau de distribution électrique peut survenir dès lors que la consommation des charges 2 varie, ou encore, que les sources de production décentralisées 5 injectent du courant dans le réseau de distribution électrique 1.

Le changement d'état du réseau de distribution électrique 1 n'est en général pas homogène, et entraine ainsi des déséquilibres, de la tension par exemple.

Le procédé selon l'invention comprend donc une étape a. de mesure d'au moins une grandeur physique A au niveau du noeud principal N. Par mesure d'au moins une grandeur physique A au niveau du noeud principal N, nous entendons que l'au moins une grandeur physique A est mesurée pour chacun des départs de lignes de distribution 3.

La mesure de l'au moins une grandeur physique A peut être exécutée par une pluralité de capteurs, dits « capteurs amonts », disposés au niveau du noeud principal N.

L'au moins une grandeur physique A peut comprendre : la tension, le courant, la puissance active P, la puissance réactive Q.

L'étape a. comprend également la mesure d'au moins une grandeur physique B au niveau d'une pluralité de points 4 de mesure du réseau de distribution 1. Les points 4 sont des points d'apprentissage du modèle objet de la présente invention. Aussi, tout au long de la description, nous ne ferons référence qu'aux points 4, étant entendu que points 4 signifiera points d'apprentissage. De manière avantageuse, les points 4 de mesure sont disposés à proximité des terminaisons des lignes de distribution 3. Par terminaison d'une ligne de distribution 3, nous entendons une extrémité de ladite ligne de distribution 3 autre que son départ. Les lignes de distribution 3 pouvant être ramifiées, il est alors entendu qu'elles peuvent comprendre plusieurs terminaisons.

La mesure de l'au moins une grandeur physique B peut être exécutée par une pluralité de capteurs, dits « capteurs avals », disposés au niveau des points 4 de mesure.

L'étape a) est exécutée pendant une première période temporelle de sorte que pendant ladite période les mesures de l'au moins une grandeur physique A peuvent être corrélées avec les mesures de l'au moins une grandeur physique B.

La première période temporelle peut être d'une durée inférieure à un mois, plus particulièrement d'une durée inférieure à une semaine.

La mesure de l'au moins une grandeur physique A et de l'au moins une grandeur physique B peut être exécutée de manière continue pendant toute la durée de la première période temporelle.

La mesure de l'au moins une grandeur physique A et de l'au moins une grandeur physique B peut être exécutée à intervalles de temps réguliers, par exemple toutes les heures, pendant la première période temporelle.

L'ensemble des mesures de grandeurs physiques A et B constituent des données d'apprentissage.

L'établissement du modèle prédictif de changement d'état du réseau de distribution électrique 1 comprend également une étape b. permettant de corréler les au moins une grandeur physique A et les au moins une grandeur physique B, par exemple par une méthode d'apprentissage machine (« Machine Learning » selon la terminologie Anglo-Saxonne). L'apprentissage machine comprend la construction d'une fonction f_{k,p} (les indices p et k étant, respectivement, relatifs à la phase et au capteur aval considéré), à partir des données d'apprentissage, permettant la prédiction de la ou des valeurs de l'au moins une grandeur physique B au niveau des points 4 à partir de la mesure de l'au moins une grandeur physique A.

La construction de la fonction f_{k,p} peut comprendre une étape de minimisation de l'écart entre les valeurs de la grandeur physique B (par exemple celle mesurée par le capteur aval k, V _{distant k,p}) d'apprentissage et leur prédiction par ladite fonction.

L'apprentissage machine peut être mis en oeuvre par une méthode d'apprentissage nommée « Support Vector Regression ». La mise en oeuvre des méthodes d'apprentissage machine est connue de l'homme du métier et, à cet égard, ce dernier trouvera une description d'une de ces méthode dans le document [1] cité à la fin de la description.

A titre d'exemple, la grandeur physique B peut être la tension V_{distantk,p} au niveau des points 4, et l'au moins une grandeur physique A peut comprendre la tension V_{N} et le courant I_{N} au niveau du noeud principal N. La fonction f_{k,p} permet ainsi de prédire de la tension V_{distant k, p} au niveau des points 4 du réseau de distribution électrique 1 à partir de la mesure de la tension V_{N} et du courant I_{N} au niveau du point principal N (grandeur physique A).

Le modèle prédictif selon l'invention ne nécessite que la mesure de l'au moins une grandeur physique A avec les seuls capteurs amonts disposés au niveau du noeud principal N. Les capteurs avals disposés au niveau des points 4 peuvent être retirés.

Le modèle selon l'invention ne nécessite pas d'établir un modèle théorique du comportement du réseau de distribution électrique 1.

Par ailleurs, les inventeurs ont avantageusement remarqué que la simple connaissance de la tension V_{N} et du courant I_{N} (V_{N} et I_{N} étant l'au moins une grandeur A) permet de prédire avec un degré de certitude suffisant la tension V_{distant} au niveau des points 4 du réseau de distribution électrique 1.

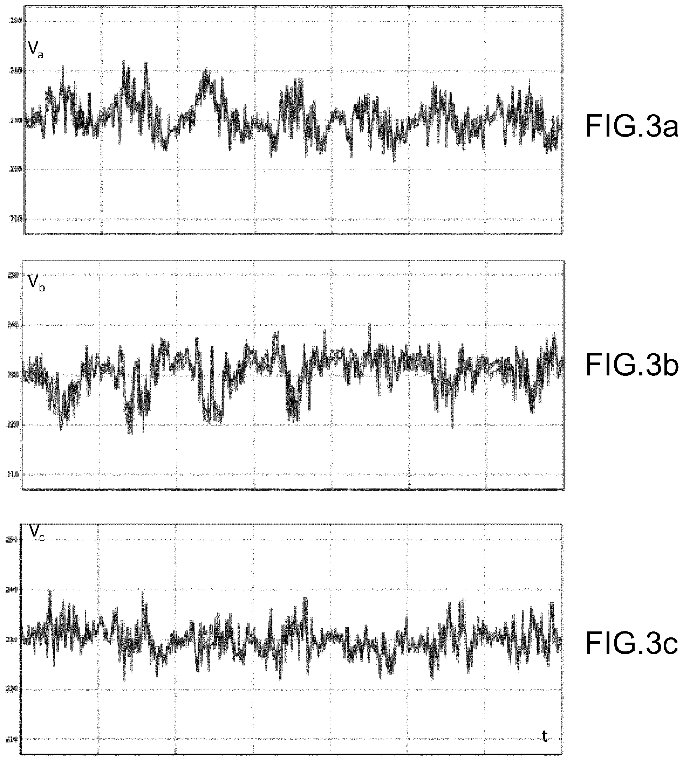

Les figures 3a, b, et c représentent l'évolution temporelle des tensions, mesurée et prédite avec le modèle prédictif, au niveau d'un point 4 pour chacune des phases a, b, et c, d'un réseau de distribution triphasé. Le modèle prédictif, dans cet exemple, relie la tension V_{N} et le courant I_{N} au niveau du noeud principal N avec la tension V_{distant k, p} (grandeur physique B) au niveau des points 4.

La très faible déviation entre tension prédite et tension mesurée valide le modèle prédictif selon l'invention qui se distingue tant par sa simplicité de mise en oeuvre que par son efficacité vis-à-vis des modèles comprenant une modélisation du réseau de distribution électrique.

De manière avantageuse, le modèle prédictif peut être spécifique et distinguer, par exemple, les saisons, le jour de la nuit, ou encore les jours de semaine (du lundi au vendredi) des jours de fin de semaine (samedi et dimanche). Ces distinctions permettent de raffiner le modèle prédictif et par conséquent de lui conférer une plus grande précision.

Le modèle prédictif est avantageusement mis en oeuvre avec un calculateur, par exemple un ordinateur.

Plus particulèrement, l'étape b) de corrélation peut être exécutée par le calculateur.

Selon un deuxième aspect, l'invention concerne également un procédé de régulation de tension du réseau de distribution électrique 1 mettant en oeuvre le modèle prédictif précédemment décrit.

Le procédé de régulation selon l'invention vise à maintenir l'au moins une grandeur physique B dans une gamme de valeurs prédéterminées au niveau des points 4.

Par ailleurs le procédé de régulation selon l'invention n'impose de disposer des capteurs amonts qu'au niveau du noeud principal N du réseau de distribution d'électricité 1. En effet, dès lors que le modèle prédictif est connu, seule la valeur de la grandeur physique A est nécessaire pour pouvoir prédire la valeur de la grandeur physique B au niveau du point 4.

Plus particulièrement, le modèle prédictif peut être mis à profit pour réguler la valeur de la grandeur physique B pour simple ajustement de la grandeur physique A, par exemple pour maintenir ladite grandeur physique B dans une gamme de valeurs prédéterminées.

La grandeur physique A peut être ajustée par le poste de transformation 7.

Plus particulièrement, le poste de transformation peut être pourvu d'un régulateur 9 destiné à contrôler l'ajustement de la grandeur physique A par le transformateur 8.

De manière avantageuse, le régulateur 9 collecte la mesure de l'au moins une grandeur physique A à partir des capteurs amonts disposés au niveau du noeud principal N, et prédit la valeur de l'au moins une grandeur physique B au niveau des points 4. Dès lors qu'une valeur de l'au moins une grandeur physique B est en dehors de la gamme de valeurs prédéterminée, le régulateur impose au transformateur 8 de réajuster la valeur de l'au moins une grandeur A.

A titre d'exemple, l'invention peut être mise en oeuvre pour la régulation d'un réseau BT interfacé au niveau de son noeud principal N à un réseau MT par l'intermédiaire d'une poste MT/BT. Le poste MT/BT permet la régulation du réseau MT/BT.

Un poste MT/BT du type « Smart Transformer » décrit dans la demande de brevet FR 3 004 284 permet une régulation dynamique de la tension d'alimentation du réseau BT.

### RÉFÉRENCES

[1] Alex J. Smola, Bernhard Schölkopf, « A tutorial on support vector regression", Statistics and Computing, August 2004, Volume 14, Issue 3, pp. 199-222.

## Revendications

1. Procédé de construction d'un modèle prédictif de changement d'état d'un réseau de distribution électrique (1) destiné à être mise en oeuvre pour la régulation dynamique dudit réseau, le réseau de distribution électrique comprenant un noeud principal (N) alimentant en courant une pluralité de charges (2) connectées audit noeud principal (N) par l'intermédiaire d'au moins une ligne de distribution (3), le procédé comprenant :
a) une étape de mesure de l'évolution, pendant une première période temporelle, d'au moins une grandeur physique A au niveau du noeud principal (N), et d'au moins une grandeur physique B au niveau d'une pluralité de points (4) de mesure du réseau (1) ;
b) une étape de corrélation, exécutée au moyen d'un calculateur, de l'au moins une grandeur A et de l'au moins une grandeur B mesurées à l'étape a), de sorte que la connaissance de l'au moins une grandeur physique A, au niveau du noeud principal (N) permette de prédire la valeur de l'au moins une grandeur physique B au niveau de la pluralité de points (4) de mesure du réseau (1).

2. Procédé selon la revendication 1, dans lequel l'étape b. de corrélation comprend un algorithme d'apprentissage machine, avantageusement selon une méthode machine à vecteurs de support.

3. Procédé selon la revendication 1 ou 2, dans lequel la grandeur physique A comprend au moins une des grandeurs physiques choisie parmi : la tension, l'intensité du courant, la puissance active, la puissance réactive.

4. Procédé selon l'une des revendications 1 à 3, dans lequel la grandeur physique B est une tension.

5. Procédé selon l'une des revendications 1 à 4, dans lequel l'étape a. de mesure est réalisée par une pluralité de capteurs localisés au niveau du noeud (N) principal et de la pluralité de points (4) de mesure.

6. Procédé selon l'une des revendications 1 à 5, dans lequel le réseau de distribution électrique (1) comprend des sources de production décentralisées (5), avantageusement les sources de production décentralisées comprennent des sources d'énergie renouvelables.

7. Procédé selon l'une des revendications 1 à 6, dans lequel la première période temporelle est d'une durée inférieure à un mois, avantageusement inférieure à une semaine.

8. Procédé selon l'une des revendications 1 à 7, dans lequel l'au moins une ligne de distribution est ramifiée et comprend une pluralité de terminaisons constituants des points de mesure (4) de la grandeur physique B.

9. Procédé selon l'une des revendications 1 à 8, dans lequel le réseau de distribution électrique (1) comprend trois phases et un neutre, les étapes a) et b) étant exécutées sur les trois phases et le neutre.

10. Procédé de régulation dynamique d'un réseau de distribution électrique (1) comprenant un noeud principal (N) alimentant en courant une pluralité de charges (2) connectées audit noeud principal (N) par l'intermédiaire d'au moins une ligne de distribution (3), la valeur d'au moins une grandeur physique B en une pluralité de points (4) du réseau de distribution électrique (1) étant corrélée à la valeur d'une grandeur physique A au noeud principal (N) selon le modèle prédictif construit selon l'une des revendications 1 à 9,
le procédé comprenant la régulation de l'au moins une grandeur physique A de manière à maintenir la valeur de l'au moins une grandeur physique B dans une gamme de valeurs prédéterminées.

11. Procédé selon la revendication 10, dans lequel le réseau de distribution électrique (1) est interfacé à un réseau d'alimentation (6) au niveau du noeud principal (N) par l'intermédiaire d'un poste de transformation (7).

12. Procédé selon la revendication 11, dans lequel l'ajustement de la grandeur physique A est exécuté par le poste de transformation (7).

13. Procédé selon la revendication 12, dans lequel le poste de transformation (7) comprend un régulateur (9) destiné à exécuter la mesure de la valeur de l'au moins une grandeur physique A et la prédiction de la valeur de l'au moins une grandeur physique B, ledit régulateur étant également adapté pour commander au poste de transformation (7) l'ajustement de la valeur de l'au moins une grandeur physique A.

14. Procédé selon l'une des revendications 10 à 13, dans lequel le réseau de distribution électrique (1) est un réseau BT.

15. Procédé selon l'une des revendications 10 à 14, dans lequel le réseau de distribution électrique (1) comprend des sources de production décentralisées (5), avantageusement les sources de production décentralisées comprennent des sources d'énergie renouvelables.
